# EUROPEAN PATENT APPLICATION

(11) **EP 2 221 664 A1**
(43) Date of publication of application: **25.08.2010**
(21) Application number: 09153205.1
(22) Date of filing: 19.02.2009
(51) Int. Cl.: G03F 7/00, G03F 7/027, G03F 7/004

(54) **Nanolithography process**

(71) Applicant: Solvay Solexis S.p.A., 20021 Bollate (MI) (IT); AMO GMBH, 52074 Aachen (DE)
(72) Inventor: Koo, Namil, 52074, Aachen (DE); Plachetka, Ulrich, 41239, Mönchengladbach (DE); Moormann, Christian, 52074, Aachen (DE)
(74) Representative: Benvenuti, Federica

(57) **Abstract**

The invention pertains to a method for replicating a pattern, said method comprising:
(a) providing patterned template, wherein said patterned template comprises a patterned template surface having a plurality of recessed or protruded areas formed therein;
(b) contacting a volume of a curable perfluoropolyether composition [composition (C)] with said patterned template surface, said composition comprising:
- at least one functional perfluoropolyether compound [compound (E)], said compound (E) comprising a (per)fluoropolyoxyalkylene chain [chain (R_{f})], wherein the molecular weight of said chain R_{f} is more than 1000 and less than 3500; and at least two unsaturated moieties; and
- at least one photoinitiator;

(c) submitting to UV radiations said composition (C) to yield a mould comprising a patterned mould surface, and separating said mould from said patterned template.

## Description

### Technical Field

This invention pertains to an improved process for imprint technology, suitable for the manufacture of nanopatterned parts.

### Background Art

The field of nanotechnology and microelectronics are closely related, as integrated circuit features are now continuously pushed to the 100 nm regime and beyond. Thus, in order to keep ahead of the ever shrinking feature size, research on manufacturing and metrology methods endeavours to truly enable nanotechnology industries to come to fruition.

Imprint lithography has been recognized as having the potential to offer viable, cost-effective alternatives to optical lithography for manufacturing integrated circuits, optical components, and other devices for sub-1 00 nm features. In particular, UV-nanoimprint technology using flexible moulds (soft UV-NIL), which comprises fabricating soft moulds from a master by cast moulding , and repeatedly replicating patterns with said soft moulds has gained attention.

Polydimethylsiloxane (PDMS) based materials have served as materials of choice in soft-lithography; actually the use of these soft, elastomeric materials offer numerous attractive properties: high transparency to UV-rays, low Young's modulus. Nevertheless, certain inherent properties of PDMS materials (e.g. too low Young's modulus causing moulds distortion, sagging and bending of patterned features; too high a surface energy and swelling by organic molecules causing defects in patterns replications) represented the driving force to introduce fluorochemicals as antisticking surface treatment agents and/or as mould raw-materials alternative to PDMS.

Thus, document JP 2004351693 16.12.2004 describes the use of certain functional perfluoropolyether materials for coating of a Si mould, to be used for manufacturing polymeric patterns by imprint technology.

WO 2005/101466 (UNIVERSITY OF NORTH CAROLINA) 27.10.2005 discloses the use of fluorinated elastomer-based materials, in particular perfluoropolyether (PFPE)-based materials, for manufacturing soft moulds from suitable patterned masters, said moulds being used for imprinting on UV-curable photoresists patterns of said masters. In particular, a perfluoropolyether diacrylate compound of formula: 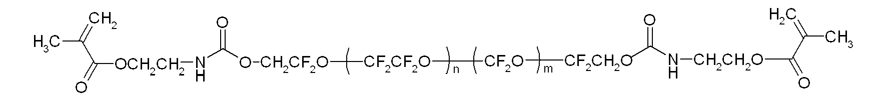 wherein the PFPE block has a molecular weight of about 3800 is disclosed.

Similarly, WILES, Kenton B., et al. Soft Lithography usinf perfluorinated polyether molds and PRINT technology for fabrication of 3-D arrays on glass substrates. Proceedings of the SPIE- The International Society for OpticalEngineering. 2006, vol.6151, p.61513F. disclose the use of photocured perfluorinated perfluoropolyether moulds for fabricating articles from curable precursors precisely replicating moulds' patterns.

Nevertheless, when applying these PFPE functional materials to the replication from masters having nanostructured patterns, it has been found that certain sagging and deformation problems in moulds having recesses or protrusion of sizes below 100 nm (e.g. 50 nm) might impair performances of moulds obtained therefrom in imprint technologies.

There is thus still a need in the art for an improved method for reproducing accurately and reliably (nano)patterns using flexible moulds, enabling suitable reproduction of features having nanometric sizes (e.g. 50 nm) and providing acceptable mould release properties, while being compatible with current technologies, including soft UV nanoimprint lithography, e.g. with standard masters (e.g. silicon masters) and standard plastics (e.g. photoresists).

### Disclosure of Invention

It is thus an object of the present invention a method for replicating a pattern, said method comprising:
(a) providing patterned template, wherein said patterned template comprises a patterned template surface having a plurality of recessed or protruded areas formed therein;
(b) contacting a volume of a curable perfluoropolyether composition [composition (C)] with said patterned template surface, said composition comprising:
   - at least one functional perfluoropolyether compound [compound (E)], said compound (E) comprising a (per)fluoropolyoxyalkylene chain [chain (R_{f})], wherein the molecular weight of said chain R_{f} is more than 1000 and less than 3500; and at least two unsaturated moieties; and
   - at least one photoinitiator;
(c) submitting to UV radiations said composition (C) to yield a mould comprising a patterned mould surface, and separating said mould from said patterned template.

The Applicant has found that by appropriate selection of the molecular weight of the chain R_{f} of the compound (E) is advantageously possible to obtain moulds which possess adequate mechanical and surface release properties to notably avoid pairing and sagging of moulds obtained therefrom, thus enabling advantageously substantially defect-free reproduction of patterns with a sub-50 nm resolution.

It has thus been found essential for the purposes of the invention for the molecular weight of the chain R_{f} to be comprised more than 1000 and less than 3500. It has been found that when the molecular weight of the chain R_{f} exceed said boundaries, then the shaped moulds obtained therefrom are endowed with unsatisfactory Young modulus: in other words, moulds are too soft and undergo sagging and pairing in patterned features, so that replication of master's features is inaccurate or even impossible, in particular when targeting resolution of below 50 nm.

On the contrary, when molecular weight of chain R_{f} decreases below above cited boundaries, then fluorinated weight fraction correspondently decreases with respect to hydrogenated functional moieties: as a consequence, surface energy and mould release properties are affected and issues in detaching both soft moulds from masters (with consequent risks in damaging said masters) and from patterned final parts occur.

For the avoidance of doubt, the term "(per)fluoropolyoxyalkylene chain (chain R_{f})" is hereby intended to denote a chain comprising recurring units (R1), said recurring units having general formula: -(CF₂)ₖ-CFZ-O-, wherein k is an integer of from 0 to 3 and Z is selected between a fluorine atom and a C₁-C₅ perfluoro(oxy)alkyl group.

Chain R_{f} preferably complies with formula: -(CF₂O)ₚ(CF₂CF₂O)_{q}(CFYO)ᵣ (CF₂CFYO)ₛ-(CF₂(CF₂)_{z}CF₂O)ₜ-
wherein Y is a C₁-C₅ perfluoro(oxy)alkyl group, z is 1 or 2; and p, q, r, s, t are integers ≥ 0, selected such that the molecular weight of said chain R_{f} complies with above mentioned requirements.

Chain R_{f} more preferably complies with formula: -(CF₂O)ₚ^{,}(CF₂CF₂O)_{q}^{,}-
wherein p' and q' are integers ≥ 0, selected such that the molecular weight of said chain R_{f} complies with above mentioned requirements.

Preferably, the molecular weight of said chain R_{f} is between 1200 and 3500, more preferably between 1200 and 3000, still more preferably between 1500 and 3000, even more preferably between 1500 and 2500; it is thus understood that in corresponding preferred structures as above detailed p, q, r, s, t, p' and q' represent integers selected so as to comply with these molecular weight requirements.

Unsaturated moieties of the compound (E) are not particularly restricted provided that they possess a suitable reactivity in UV curing conditions.

Typically, compound (E) is selected among those of formula: T₁-J-R_{f}-J'-T₂,
wherein R_{f} represents a chain R_{f} as above detailed, J and J', equal to or different from each other, are independently a bond or a divalent bridging group, and T₁ and T₂, equal to or different from each other, are selected from the group consisting of:
(A) -O-CO-CR_{H}=CH₂,
(B) -O-CO-NH-CO-CR_{H}=CH₂,
(C) -O-CO-R^{A}-CR_{H}=CH₂,
   wherein R_{H} is H or a C₁-C₆ alkyl group; R^{A} is selected from the group consisting of:
   (j) -NH-R^{B}-O-CO-
   (jj) -NH-R^{B}-NHCOO-R^{B}-OCO-;
   R^{B} being a divalent group selected from the group consisting of C₁-C₁₀ aliphatic group, C₅-C₁₄ cycloaliphatic group; C₆-C₁₄ aromatic or alkylaromatic group.

Among preferred compounds (E) mention can be notably made of :
(1) acrylate-derivatives of formula: 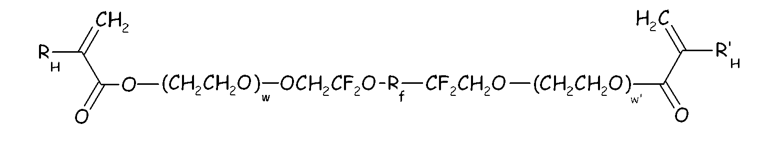 wherein w and w', equal to or different from each other, are independently an integer from 0 to 5, R_{f} representing a chain R_{f} as above detailed and R_{H} and R'_{H} being H or a C₁-C₆ alkyl group;
(2) acrylamide-urea derivatives of formula: 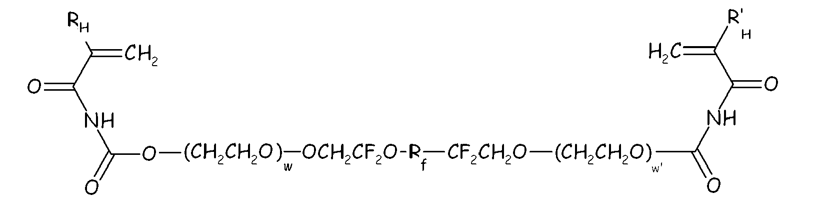 wherein w and w', R_{f}, and R_{H} and R'_{H} have same meaning as above detailed_{;}
(3) acrylate-urethane derivatives of formula: 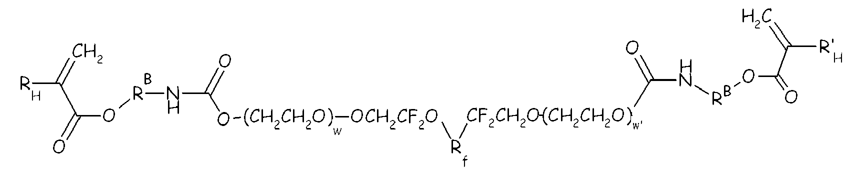 wherein w and w', R_{f}, R_{H} and R'_{H} have same meaning as above detailed, and each of R^{B}, equal to or different from each other, is a divalent group selected from the group consisting of C₃-C₁₀ aliphatic group, C₅-C₁₄ cycloaliphatic group; C₆-C₁₄ aromatic or alkylaromatic group; and
(4) urethane-amide-acrylate derivatives of formula: 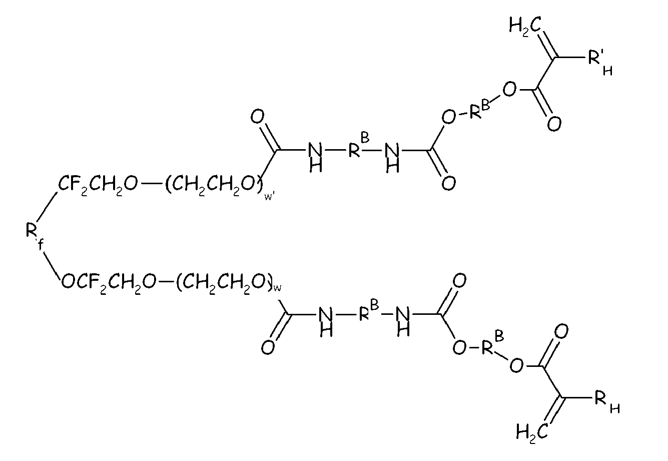
wherein w and w', R_{f} ,R^{B}, and R_{H} and R'_{H} have same meaning as above detailed.

Most preferred compounds (E) are those selected from the group consisting of: 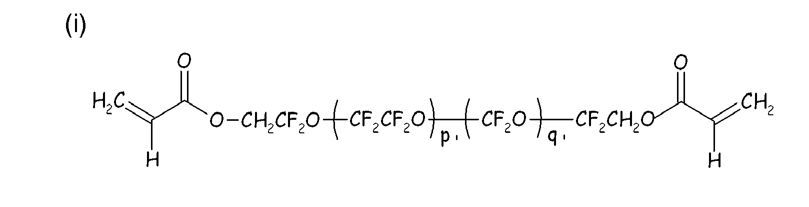 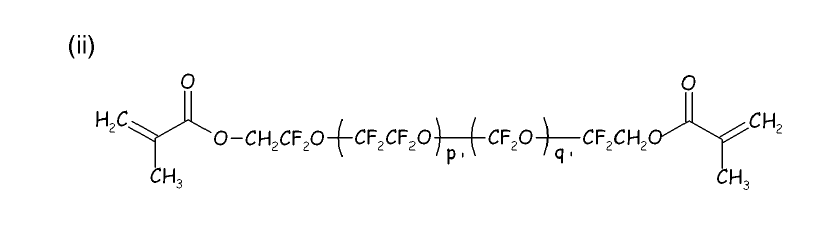 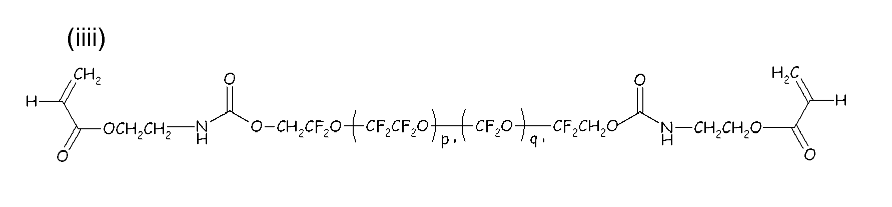 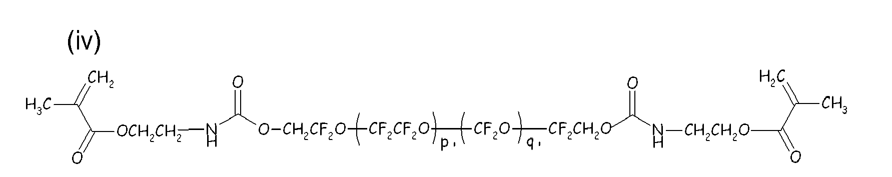 wherein in formulae here above p' and q' are selected so that the molecular weight of chain R_{f} is comprised in above mentioned boundaries.

The choice of the photoinitiator is not limited; all compounds enabling suitable generation of radicals under UV radiation will be suitable in the process of the invention.

It is generally understood that photoinitiators are generally selected from the group consisting of following families:
- alpha-hydroxyketones; among alpha-hydroxyketones, mention can be made of 1-hydroxy-cyclohexyl-phenyl-ketone; 2-hydroxy-2-methyl-1-phenyl-1-propanone; and 2-hydroxy-1-[4-(2-hydroxyethoxy)phenyl]-2-methyl-1-propanone;
- phenylglyoxylates; among phenylglyoxylates, mention can be made of methylbenzoylformate; oxy-phenyl-acetic acid 2-[2-oxo-2-phenyl-acetoxy-ethoxy]-ethyl ester, and oxy-phenyl-acetic 2-[2-hydroxy-ethoxy]-ethyl ester;
- benzyldimethyl-ketals; among benzyldimethyl-ketals, mention can be made of alpha, alpha-dimethoxy-alpha-phenylacetophenone;
- alpha-aminoketones; among alpha-aminoketones, mention can be made of 2-benzyl-2-(dimethylamino)-1-[4-(4-morpholinyl) phenyl]-1-butanone, and 2-methyl-1-[4-(methylthio)phenyl]-2-(4-morpholinyl)-1-propanone;
- bis acyl-phosphines; among bis acyl-phosphines, mention can be made of diphenyl-(2,4,6-trimethylbenzoyl)-phosphine oxide.

Among photoinitiators, those which are liquid at room temperature are preferred.

A class of photoinitiators which gave particularly good results has been that of alpha-hydroxyketones, in particular 2-hydroxy-2-methyl-1-phenyl-1-propanone.

The amount of photoionitiator is not particularly limited. Generally, it will be used in an amount of at least 0.01 % wt, preferably of 0.05 % wt, more preferably of 0.1 % wt, with respect to the weight of the compound (E).

Also, said photoinitiator is generally used in an amount of at most 10 % wt, preferably at most 7.5 % wt, more preferably at most 5 % wt, with respect to the weight of the compound (E).

In particular, as residues from photoinitiator might possibly impair durability of moulds, it is generally preferred to minimize amount as much as possible photoinitiator.

The composition (C) might possibly comprise further additives and ingredients, like notably thermal stabilizers, antioxidants, viscosity modifiers, and the like.

It is nevertheless generally understood that compound (E) is the major component of the composition (C); minor amounts of other components might be present to the extent that they do not modify properties of said compound (E).

Step (c) of the process of the invention, i.e. submitting to UV radiations composition (C) is carried out according to standard methods; UV radiations employed generally have a wavelength in the range of from 200 nm to 350 nm.

Among sources of UV radiations which can be used, mention can be made of mercury lamps, xenon arc lamps (commonly used as sunlight simulators), deuterium arc lamps, mercury-xenon arc lamps, metal-halide arc lamps, and tungsten-halogen incandescent lamps.

Radiation dose will be adjusted by the skilled in the art as a function of the type and concentration of photoinitiator; generally, good results have been obtained with radiation doses of at least 2 J/cm², preferably 5 J/cm².

It is also preferred for achieving improved curing rates and minimizing degradation reactions to submit composition (C) to UV radiations in step (c) under a substantially oxygen-free atmosphere. Typically step (c) will be carried out under nitrogen atmosphere.

Cured soft moulds are then advantageously separated from the template.

It may be useful to treat the patterned template (otherwise called master) with suitable surface treating agents. Among them fluoro-compounds containing silane moieties can be used. Mention can be notably made of certain fluorinated silanes, such as trichloro-(1H,1H, 2H, 2H-perfluorooctyl)silane, (3-trichlorosilyl)propylmethacrylate, or of certain functional (per)fluoropolyether having silane moities (e.g. FLUOROLINK® S10, commercially available from Solvay Solexis S.p.A).

Nevertheless, the use of said surface treatment agents is not typically mandatory, as the composition (C) already provides for suitable mould-release properties.

Typically, the method of the invention further comprises:
(d) contacting said patterned mould surface with a (pre)polymer composition [composition (P)];
(e) processing said composition (P) to yield an article having a patterned surface, and separating said article from said mould.

The pattern of the patterned mould surface obtained from step (C) of the process of the present invention is advantageously a negative replication of the pattern of the patterned template surface.

The pattern of the article patterned surface as obtained in step (E) of the process of the present invention is advantageously a replication of the pattern of the patterned template surface.

The selection of the (pre)polymer composition is not particularly limited and will be selected taking into account the particular processing technique to be used. Either thermoplastic or thermosetting/curable (pre)polymer composition (P) can be used.

In case of thermoplastic (pre)polymer compositions, in step (d) it can be possible to generate patterned structure in the article by using a suitable solvent which can dissolve or soften the composition (P) without affecting the mould. Thus, according to this embodiment, the mould can be contacted or wetted with said solvent and then contacted with the surface of a substrate of composition (P). Said solvent is generally understood to dissolve or swell a thin layer of said composition (P) substrate, and said softened or gelled layer is moulded against the patterned surface of the mould. Dissipation and/or evaporation of the solvent during processing in step (e) advantageously enable obtaining a solid article having patterned surface complementary to the surface of the mould, thus replicating template pattern.

Still in case of thermoplastic (pre)polymer compositions, in step (d) and (e) it can be possible to generate patterned structure in the article by imprinting the pattern of the mould into the thermally softened composition (P).

Embodiments wherein composition (P) is thermosetting/curable are generally preferred.

According to these embodiments, composition (P), typically in liquid form, is generally applied to the patterned surface of the mould by standard casting techniques. Non limitative examples of said techniques are notably spinning, spraying, knife casting. The composition (P) is then processed in step (e) by curing as a solid by irradiation and/or by heating.

UV-curable compositions (P) are preferred. In step (e), processing comprises thus irradiating with UV radiation the composition (P) Those compositions, which are also often referred to as photoresists, are not particularly limited.

UV-curable (pre)polymer composition (P) generally comprises at least one photoreactive monomer or oligomer and a photoinitiator.

Said photoreactive monomer or oligomer generally comprise one or more of (meth)acryloyl and epoxy functions. Monofunctional, difunctional, tri- or multifunctional derivatives can be used.

The (meth)acrylate monomer or oligomer having at least one (meth)acryloyl group may be a fluorinated or nonfluorinated (meth)acrylate.

The monofunctional fluorinated (meth)acrylate includes 2-perfluorooctylethyl acrylate, 2-perfluorooctylethyl methacrylate, 2,2, 3, 4,4, 4-hexafluorobutyl methacrylate, 2, 2, 3, 3-tetrafluoropropyl methacrylate, trifluoroethyl methacrylate, 2-perfluoroallcylethyl acrylate and 2-perfluoroalkylethyl methacrylate.

Representative examples of the monofunctional nonfluorinated (meth)acrylate are (3-methacryloxypropyl)trimethoxysilane, (3-methacryloxypropyl)dimethylmethoxysilane, (3-acryloxypropyl)-trimethoxysilane, 2-hydroxyethyl-(meth)acrylate, 2-hydroxypropyl-(meth) acrylate, 2-hydroxybutyl-(meth)acrylate, 1-hydroxybutyl-(meth)acrylate, 2-hydroxy-3-phenyloxypropyl(meth) acrylate, tetrahydrofurfuryl-(meth)acrylate, isodecyl-(meth)acrylate, 2-(2-ethoxyethoxy)-ethyl-(meth)acrylate, stearyl(meth)acrylate, lauryl(meth)acrylate, 2-phenoxyethyl(meth)acrylate, isobornyl(meth)acrylate, tridecyl(meth)acrylate, polycarprolactone(meth)acrylate, phenoxytetraethyleneglycol-(meth) acrylate and imide-acrylate.

The difunctional nonfluorinated (meth)acrylate which may be employed in the present invention may be ethoxylated-nonylphenol(meth)acrylate, ethylene glycol di(meth)acrylate, diethylene glycol di(meth)acrylate, triethylene glycol di(meth)acrylate, tetraethylene glycol di(meth)acrylate, polyethylene glycol di(meth)acrylate, 1, 6-hexanediol di(meth)acrylate, 1,3-butylene glycol di(meth)acrylate, tripropylene glycol di(meth)acrylate, ethoxylated bisphenol A di(meth)acrylate, cyclohexane dimethanol di(meth)acrylate.

Preferred examples of the tri-or multi-functional nonfluorinated (meth)acrylate are tris[2-(acryloyloxy)ethyl]isocyanurate, trimethylol propane triacrylate, ethylene oxide added trimethylol propane triacrylate, pentaerythritol triacrylate, tris(acrylooxyethyl)isocyanurate, dipentaerythritol hexaacrylate and caprolactone denatured dipentaerythritol hexaacrylate.

Representative examples of the epoxy monomer or oligomer having at least one epoxy group include (3-glycidyloxypropyl)triethoxysilane, 3,4-epoxycyclohexylmethyl-3, 4-epoxy cyclohexane carboxylate, bis- (3, 4-epoxycyclohexyl) adipate, 3-ethyl-3-hydroxymethyl-oxetane, 1, 2-epoxyhexadecane, alkyl glycidyl ether, 2-ethyl hexyl diglycol glycidyl ether, ethyleneglycol diglycidyl ether, diethyleneglycol diglycidyl ether, PEG#200 diglycidyl ether, PEG#400 diglycidyl ether, propyleneglycol diglycidyl ether, tripropyleneglycol diglycidyl ether, PPG#400 diglycidyl ether, neopentylglycol diglycidyl ether, 1,6-hexanediol diglycidyl ether, hydrogenated bisphenol A diglycidyl ether, diglycidyl ether of propyleneoxide modified bisphenol A, dibromo neopentylglycol diglycidyl ether and trimethylolpropane triglycidyl ether.

Preferred photoreactive monomers or oligomers are those comprising sil(ox)ane moieties; among these preferred compounds, mention can be made of (3-glycidyloxypropyl)triethoxysilane, (3-methacryloxypropyl)trimethoxysilane, (3-methacryloxypropyl)dimethylmethoxysilane, (3-acryloxypropyl)-trimethoxysilane.

Good results have been obtained when using (3-methacryloxypropyl)trimethoxysilane.

As per the photoinitiator, same photoinitiators as those described for composition (C) can be used.

Composition (P) can further comprise additional additives and ingredients.

In particular, composition (P) possibly comprises inorganic fillers; more particularly inorganic fillers having sub-micron or nanometric sizes. Thus, the composition (P) can comprise inorganic filler having an average particle size of less than 1 µm, preferably of less than 500 nm, more preferably of less than 50 nm.

Said inorganic fillers are advantageously selected among inorganic oxides, like notably, SiO₂, TiO₂, ZrO₂, Al₂O₃ and mixed oxides therefrom.
Silica particles are particularly advantageous.

For replicating patterns having structures features of less than 50 nm, SiO₂ and/or ZrO₂ particles having average sizes comprised between 1 and 15 nm can be advantageously used.

The invention will be now described with reference to the following examples, whose purpose is merely illustrative and not intended to limit the scope of the invention.

EXAMPLES

### Preparative example 1: Synthesis of a functional PFPE compound with R_{f} having M_{w} of 1600

In a 0.5 I flask, equipped with a mechanical stirrer, a dropping funnel and a refrigeration column, 250 g of an hydroxyl-PFPE derivative of formula: HOCH₂CF₂O(CF₂CF₂O)ₚ(CF₂O)_{q}OCF₂CH₂OH, wherein p and q are integers such that the a average molecular weight is 1600 (0.3 eq), 0.03 g of 3,5-di-tert-butyl-4-hydroxytoluene (BHT), 0.5 ml of a 20% (w/v) solution of tin dibutyldilaurate in 2-Butanone (MEK) were introduced under inert atmosphere and the temperature was raised up to 50 °C. Under nitrogen, 46.5 g of 2-isocyanatoethyl methacrylate (EIM, MW= 155; 0.3 eq) were slowly dropped, while maintaining the reaction temperature below 60°C and the mixture was then kept under stirring for 2 hrs.
The reaction was followed by means of FT-IR analysis, monitoring the disappearance of absorption at 2250 cm⁻¹ typical of the isocyanate band, and by means of ¹⁹F-NMR, evaluating the shifts of the signals of the preterminal CF₂ groups from -81.3 ppm and of -83.3 ppm when linked to the CF₂CH₂OH group to -77.5 and -79.5 ppm when bounded to the urethane moiety. Upon filtration through a 0.2 µm PTFE membrane, 292 g of a functional PFPE compound complying with formula: 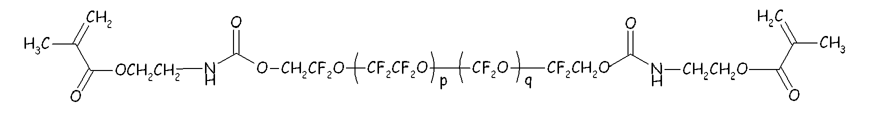 , with p and q being as above, were then recovered with 98.5 yield.

### Preparative example 2: Synthesis of a functional PFPE compound with R_{f} having M_{w} of 3817

Same procedure as described in example 1, but using as hydroxyl PFPE precursor 250 g of a derivative of formula HOCH₂CF₂O(CF₂CF₂O)_{p'}(CF₂O) _{q'}DCF₂CH₂OH, with p'/q'=0.9, p' and q 'being such that the M_{w} is 3817 (0.127 eq ) and 19.7g of 2-isocyanatoethyl methacrylate (EIM, MW= 155; 0.3 eq). 263 g of a functional PFPE compound complying with formula: 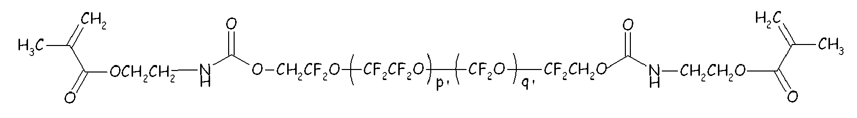 , with p' and q' being as above, were obtained with 97.5 % yield.

Test for patterns replication

### Manufacture of patterned templates:

The test design for micro-pattern replication containing pads with size ranging from 100 µm x 100 µm down to 2 µm x 2 µm was defined by optical contact lithography. Nano-gratings with period both 500 and 180 nm were defined by laser interference lithography. 50 nm periodic hole-arrays with a diameter of 30 nm were defined using electron beam writer. The defined micro-and nano-patterns were transferred into the silicon substrate by reactive ion etch (RIE). A thin standard anti-adhesion layer was coated onto the surface of all prepared masters to prevent mechanical damage of the topography during flexible mould manufacture.

### Preparation of flexible moulds:

Flexible moulds were prepared by cast moulding compositions on masters having patterned features obtained as above detailed. Thus, composition comprising required functional PFPE derivative and appropriate amount of 2-hydroxy-2-methyl-1-phenyl-1-propanone (commercially available under trade name DAROCUR^{®} 1173 from Ciba Specialty Chemicals). After degassing, the precursor was cured by UV-exposure (Hg lamp) with a dose of 10 Jcm⁻² under N₂ atmosphere and the flexible mould so obtained was separated from the master.
Comparative runs were carried out preparing flexible moulds from standard PDMS derivatives; thus SYLGARD^{®} 184 material from Dow Corning was mixed with prescribed thermal curing agent and thermally cured at 120°C for 30 minutes.

### Replication of patterns:

Flexible moulds obtained as above detailed were pressed onto a pre-polymer layer comprising 3-methacryloxypropyltrimethoxysilane, 2-benzyl-2-(dimethylamino)-1-[4-(4-morpholinyl) phenyl]-1-butanone (IRGACURE^{®} 369) and a finely divided inorganic filler (SiO₂ and ZrO₂ having particle sizes of less than 10 nm), using an imprint tool EVG 620.
The cavities of flexible moulds were filled with said pre-polymer and cured by UV-exposure with a dose of 2 Jcm⁻². After separation of the soft moulds, micro-and nano-replications were evaluated by electron microscopy.

Results are summarized here below.

Example 3 Replication of 500 nm periodic gratings with a line-width of 150 nm
Results are summarized in table 1 here below:

**Table 1**

| Run | mould precursor | Initiator | Resolution in imprinted patterns | Fidelity in imprinted patterns | SEM picture of imprinted patterns |
|---|---|---|---|---|---|
| A | ex. 1 | 4%wt | excellent | excellent | Figure 1 |
| B (compa rison) | PDMS | | good | poor | Figure 2 |
| C (compa rison) | ex. 2 | 2%wt | excellent | acceptable | Not available |

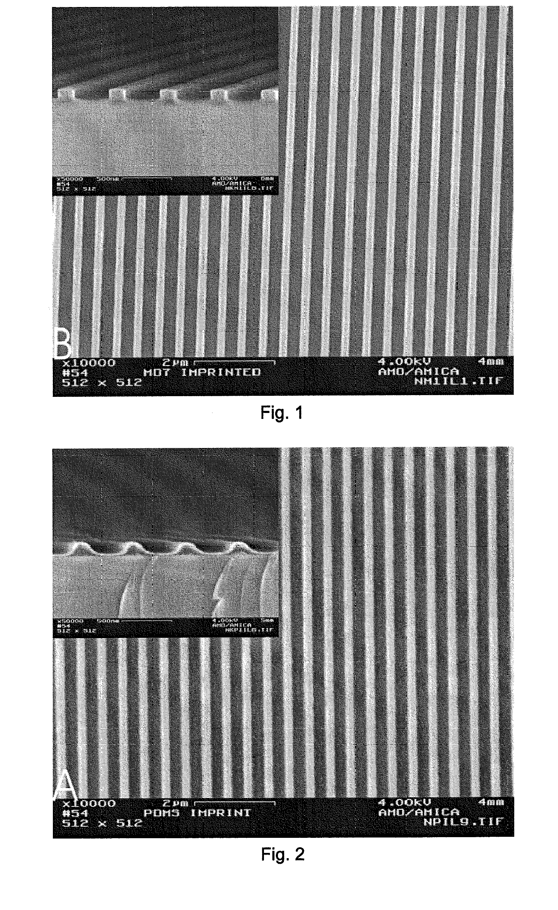

As apparent from comparison of Figure 1 and 2, in particular cross-section views, well demonstrate that only PFPE moulds enable adequate replication of side-wall profiles in imprinted patterns.

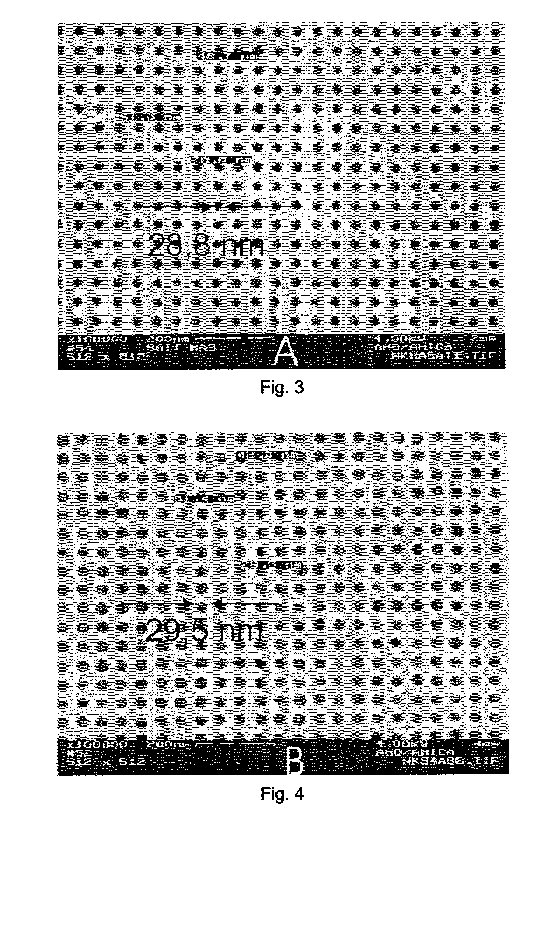

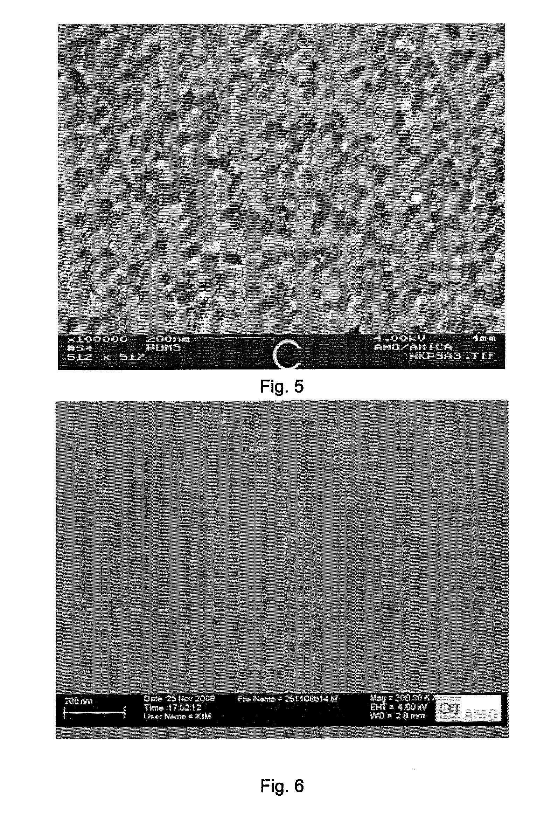

Example 4 Replication of 50 nm periodic holes with 29 nm diameter A silicon master including 50 nm periodic holes (see figure 3) with a diameter of 29 nm and spaces of 20 nm was used for fabrication of imprinted patterns.
Results are summarized in table 1 here below:

**Table 2**

| Run | mould precursor | Initiator | Resolution in imprinted patterns | SEM picture of imprinte d patterns |
|---|---|---|---|---|
| A | ex. 1 | 4%wt | excellent | Figure 4 |
| B (comparison) | PDMS | | none | Figure 5 |
| C (comparison) | ex. 2 | 2%wt | poor | Figure 6 |

Comparison between results obtained in runs 4A and 4C well demonstrate that only the PFPE material complying with the molecular weight requirements of the present invention actually enables achievement of pattern resolution down to 30 nm, wherein higher molecular weight analogous have been found to fail.

## Claims

1. A method for replicating a pattern, said method comprising:
(a) providing patterned template, wherein said patterned template comprises a patterned template surface having a plurality of recessed or protruded areas formed therein;
(b) contacting a volume of a curable perfluoropolyether composition [composition (C)] with said patterned template surface, said composition comprising:
- at least one functional perfluoropolyether compound [compound (E)], said compound (E) comprising a (per)fluoropolyoxyalkylene chain [chain (R_{f})],
wherein the molecular weight of said chain R_{f} is more than 1000 and less than 3500; and at least two unsaturated moieties; and
- at least one photoinitiator;
(c) submitting to UV radiations said composition (C) to yield a mould comprising a patterned mould surface, and separating said mould from said patterned template.

2. The method of claim 1, said method further comprising:
(d) contacting said patterned mould surface with a (pre)polymer composition [composition (P)];
(e) processing said composition (P) to yield an article having a patterned surface, and separating said article from said mould.

3. The method according to anyone of the preceding claims, wherein compound (E) is selected among those of formula: T₁-J-R_{f}-J'-T₂,
wherein R_{f} represents a (per)fluoropolyoxyalkylene chain, J and J', equal to or different from each other, are independently a bond or a divalent bridging group, and T₁ and T₂, equal to or different from each other, are selected from the group consisting of:
(A) -O-CO-CR_{H}=CH₂,
(B) -O-CO-NH-CO-CR_{H}=CH₂,
(C) -O-CO-R^{A}-CR_{H}=CH₂,
wherein R_{H} is H or a C₁-C₆ alkyl group; R^{A} is selected from the group consisting of:
(j) -NH-R^{B}-O-CO-
(jj) -NH-R^{B}-NHCOO-R^{B}-OCO-;
R^{B} being a divalent group selected from the group consisting of C₁-C₁₀ aliphatic group, C₅-C₁₄ cycloaliphatic group; C₆-C₁₄ aromatic or alkylaromatic group.

4. The method according to anyone of the preceding claims, wherein said chain R_{f} complies with formula: -(CF₂O)ₚ(CF₂CF₂O)_{q}(CFYO)ᵣ(CF₂CFYO)ₛ-(CF₂(CF₂)_{z} CF₂O)ₜ-
wherein Y is a C₁-C₅ perfluoro(oxy)alkyl group, z is 1 or 2; and p, q, r, s, t are integers ≥ 0, selected such that the molecular weight of said chain R_{f} is more than 1000 and less than 3500.

5. The method according to Claim 4, wherein compound (E) is selected from the group consisting of:
(1) acrylate-derivatives of formula: 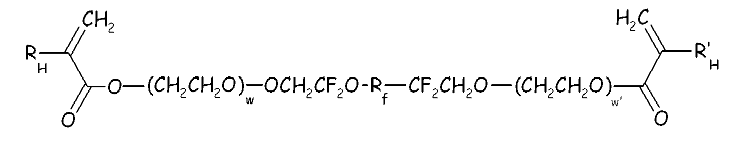 wherein w and w', equal to or different from each other, are independently an integer from 0 to 5, R_{f} representing a chain R_{f} as detailed in claim 4 and R_{H} and R'_{H} being H or a C₁-C₆ alkyl group_{;}
(2) acrylamide-urea derivatives of formula: 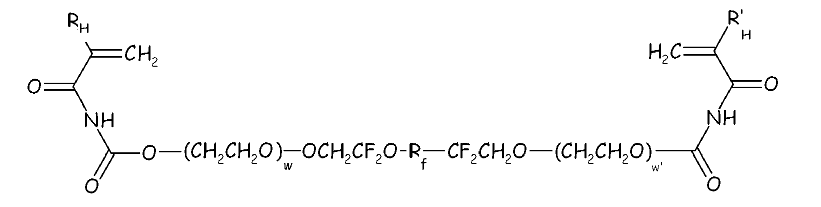 wherein w and w', R_{f}, and R_{H} and R'_{H} have same meaning as above detailed_{;}
(3) acrylate-urethane derivatives of formula: 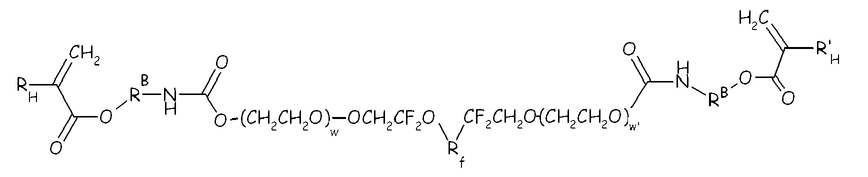 wherein w and w', R_{f}, R_{H} and R'_{H} have same meaning as above detailed, and each of R^{B}, equal to or different from each other, is a divalent group selected from the group consisting of C₃-C₁₀ aliphatic group, C₅-C₁₄ cycloaliphatic group; C₆-C₁₄ aromatic or alkylaromatic group; and
(4) urethane-amide-acrylate derivatives of formula: 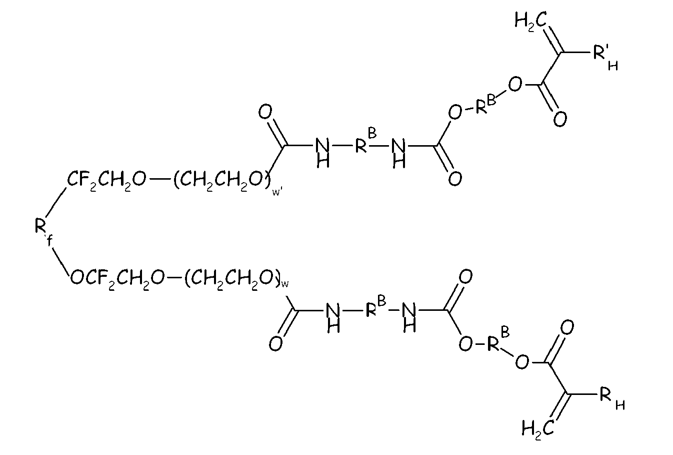
wherein w and w', R_{f} ,R^{B}, R_{H} and R'_{H} have same meaning as above detailed.

6. The method according to Claim 5, wherein compound (E) is selected from the group consisting of: 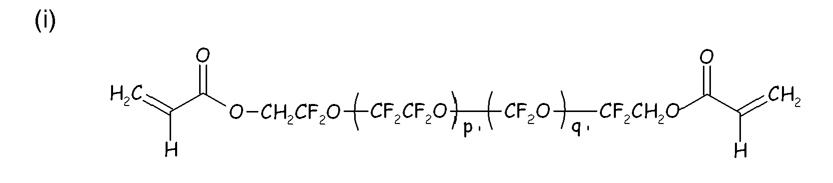 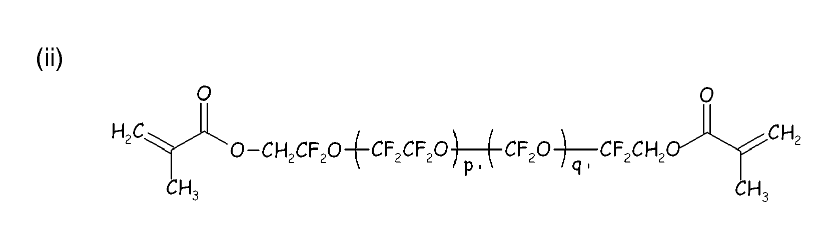 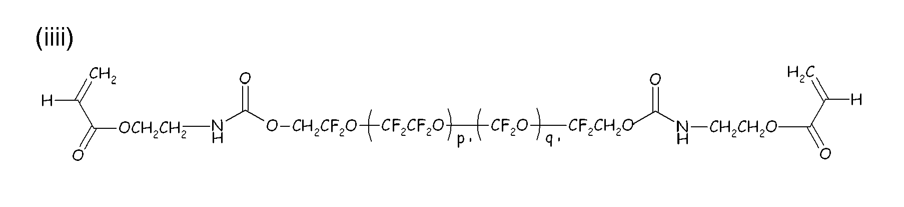 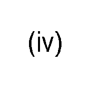 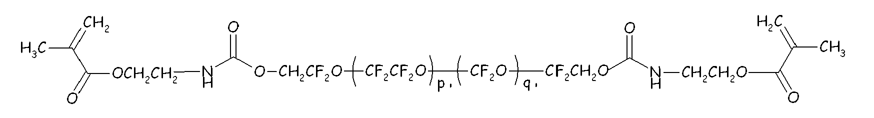 wherein in formulae here above p' and q' are selected so that the molecular weight of said chain R_{f} is more than 1000 and less than 3500, preferably is comprised between 1200 and 3000, more preferably between 1500 and 2500.

7. The method according to anyone of the preceding claims, wherein the photoinitiator is selected from the group consisting of following families:
- alpha-hydroxyketones;
- phenylglyoxylates;
- benzyldimethyl-ketals;
- alpha-aminoketones;
- bis acyl-phosphines.

8. The method according to anyone of the preceding claims, wherein the photoinitiatos is selected from the group consisting of:
- alpha-hydroxyketones selected from the group consisting of 1-hydroxy-cyclohexyl-phenyl-ketone; 2-hydroxy-2-methyl-1-phenyl-1-propanone; and 2-hydroxy-1-[4-(2-hydroxyethoxy)phenyl]-2-methyl-1-propanone;
- phenylglyoxylates selected from the group consisting of methylbenzoylformate; oxy-phenyl-acetic acid 2-[2-oxo-2-phenyl-acetoxy-ethoxy]-ethyl ester, and oxy-phenyl-acetic 2-[2-hydroxy-ethoxy]-ethyl ester;
- alpha, alpha-dimethoxy-alpha-phenylacetophenone;
- alpha-aminoketones selected from the group consisting of 2-benzyl-2-(dimethylamino)-1-[4-(4-morpholinyl) phenyl]-1-butanone, and 2-methyl-1-[4-(methylthio)phenyl]-2-(4-morpholinyl)-1-propanone; and
- diphenyl-(2,4,6-trimethylbenzoyl)-phosphine oxide.

9. The method according to anyone of the preceding claims, wherein the composition (C) is submitted to UV radiations in step (c) under a substantially oxygen-free atmosphere.

10. The method according to anyone of the preceding claims, wherein the radiation dose in step (c) is of at least 2 J/cm², preferably 5 J/cm².

11. The method according to claim 2, wherein (pre)polymer composition (P) is thermoplastic or thermosetting/curable.

12. The method according to Claim 11, wherein composition (P) is thermosetting/curable and wherein in step (d) composition (P) is applied to the patterned surface of the mould by casting techniques and then processed in step (e) by curing by irradiation and/or by heating.

13. The method according to Claim 12, wherein a UV-curable composition (P) is used and wherein in step (e), processing comprises irradiating with UV radiation said UV-curable composition (P).

14. The method of Claim 13, wherein the UV-curable (pre)polymer composition (P) comprises at least one photoreactive monomer or oligomer and a photoinitiator.

15. The method of Claim 14, wherein the photoreactive monomers or oligomers are selected from the group consisting of (3-glycidyloxypropyl)triethoxysilane, (3-methacryloxypropyl)trimethoxysilane, (3-methacryloxypropyl)dimethylmethoxysilane, (3-acryloxypropyl)-trimethoxysilane.
